# EUROPÄISCHE PATENTSCHRIFT

(11) **EP 0 416 277 B1**
(45) Veröffentlichungstag und Bekanntmachung des Hinweises auf die Patenterteilung: **27.04.1994**
(21) Anmeldenummer: 90114549.0
(22) Anmeldetag: 28.07.1990
(51) Int. Cl.: H03G 5/02

(54) **Audioanlage mit getrennter Klangregelung für verschiedene Lautsprechergruppen**
Audio amplifier with separate tone control for different loudspeaker groups
Amplificateur audio avec réglage de tonalité séparé pour divers groupes de haut-parleurs

(30) Priorität: 07.09.1989 DE 3929736
(43) Veröffentlichungstag der Anmeldung: 13.03.1991
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Fischelmayer, Heinrich, Grundig E.M.V., Kurgartenstrasse 37, D-8510 Fürth/Bay (DE)

(56) Entgegenhaltungen:
- DE-A- 3 125 332
- IEEE TRANSACTIONS ON CONSUMER ELECTRONICS. Bd. CE-33, Nr. 3, August 1987, NEW YORK US Seiten 336 - 342; P. KIRCHLECHNER: 'A Serial Bus Controlled Audioprocessor '
- PATENT ABSTRACTS OF JAPAN vol. 12, no. 449 (E-686)25. November 1988 & JP-A-63 177 699 (MAZDA MOTOR ) 21. Juli 1988
- PATENT ABSTRACTS OF JAPAN vol. 13, no. 413 (E-820)(3761) 12. September 1989 & JP-A-1 151 810 (ALPINE ELECTRON INC ) 14. Juni 1989

## Beschreibung

Die Erfindung bezieht sich auf eine Einrichtung zur getrennten Klangeinstellung für die Lautsprecher an verschiedenen Plätzen in einem Kraftfahrzeug.

Beim Einbau von Lautsprechern in einem Kraftfahrzeug muß man aus Platzgründen meistens auf verschiedene Lautsprechertypen für den Einbau an verschiedenen Stellen zurückgreifen. Da diese verschiedenen Lautsprechertypen durch verschiedene Leistungen und Bauart auch verschiedene Klangbilder ergeben, was durch die akustischen Eigenschaften des Einbauortes noch verstärkt wird, ist man bestrebt, durch getrennte Klangregelung für bestimmte Lautsprechergruppen - z.B. vorne und hinten - dennoch ein möglichst harmonisches Klangbild zu schaffen.

Dabei sollte die Klangeinstellung nicht bei jedem Wechsel der Informationsart - z.B. Sprache/Musik - erneut für vorne und hinten getrennt nötig sein. Das harmonische Klangbild bleibt erhalten, wenn die Differenz zwischen der Einstellung für vorne und hinten beibehalten wird. Deshalb werden in bekannten Ausführungen die Tonhöhenregler mechanisch so miteinander verbunden, daß der Benutzer die Möglichkeit hat, die beiden Regler gegeneinander oder gemeinsam zu verdrehen.

Eine entsprechende Anordnung wird im deutschen Gebrauchsmuster 18 11 110 beschrieben, bei dem zwei Potentiometer so angeordnet sind, daß deren Wellen koaxial einander gegenüberliegen und ins Innere eines Gehäuses vorstehen. Das Verdrehen der Potentiometerwellen erfolgt durch ein am Einstellhebel angebrachtes Zahnsegment, das in Zahnräder, die auf den Wellen befestigt sind, eingreifen.

Eine entsprechende Anordnung für nebeneinander liegende Potentiometer ist in der deutschen Offenlegungsschrift DE-OS 25 07 050 beschrieben.

Der Nachteil dieser bestehenden mechanischen Lösungen ist zum einen die Einstellungenauigkeit durch Drehübertragung mittels Zahnräder, zum anderen die umständliche Bedienung, wenn man die beiden Regler gegeneinander verdrehen will.

Bei der Klangeinstellung in mehreren Frequenzbereichen reicht oft auch der Platz auf der Bedienfläche nicht aus, um diese Regelknöpfe unterzubringen.

Aus dem Aufsatz von P. Kirchlechner: "A Serial Bus Controlled Audioprocessor" in der Zeitschrift IEEE Transactions on Consumer Electronics, Bd. C-33, Nr. 3, August 1987, S. 336-342, ist es bekannt, die Lautstärken-, Balance- und Klangeinstellung in einem Audiogerät mit Hilfe elektronischer Stellglieder innerhalb eines Audioprozessors vorzunehmen, wobei die Steuersignale seriell über einen digitalen Datenbus zugeführt werden. Zu ähnlichem Zweck wird in der japanischen Patentanmeldung 63 177 699 die Verwendung eines Audioprozessors offenbart, um neben Frequenzgangsänderungen auch Zeitverzögerungen bei der Übertragung des Nutzsignals zu erzeugen, so daß spezielle Raumklangeffekte nachgebildet und für einen wahlweisen Abruf gespeichert werden können.

Aus der deutschen Offenlegungsschrift 31 25 332 ist ferner eine voreinstellbare graphische Abgleichvorrichtung (graphic equalizer) für Audiogeräte, insbesondere Auto-Steuergeräte, bekannt, bei der zur einfachen Frequenzgangkorrektur, hauptsächlich beim Umschalten zwischen einem 2-er-Lautsprecher-System und einem 4-er-Lautsprecher-System, die vorgewählten Einstelldaten aus einem Speicher entnommen werden. Dabei wird auf einer Kontroll-Konsole angezeigt, in welchem Betriebszustand (2-er- oder 4-er-Lautsprecher-System) sich das Wiedergabegerät befindet und welche der vielfach vorprogrammierbaren Frequenzcharakteristiken gewählt wurde.

Nachteilig ist bei den vorgenannten Anordnungen, daß bei der manuellen Einstellung oder Vorprogrammierung der unterschiedlichen Frequenzgangcharakteristiken jedes der für die einzelnen Frequenzbereiche und Lautsprecher vorhandenen Einstellorgane neu abgeglichen werden muß und daß eine kontinuierliche Frequenzgangänderung mit Hilfe eines einzelnen Einstellorgans, die gleichzeitig in sämtlichen Frequenzbereichen und für alle Lautsprechergruppen wirksam wird, nicht möglich ist.

Demgegenüber ist es Aufgabe der vorliegenden Erfindung, eine Anordnung zur Klangeinstellung für verschiedene, gleichzeitig betriebene Lautsprechergruppen mit unterschiedlichen akustischen Eigenschaften anzugeben, bei der einmalig ein Frequenzgangsabgeich vorgenommen werden muß, um ein harmonisches Klangbild zu erzielen, und bei der zur kontinuierlichen gemeinsamen Frequenzgangsänderung nur noch ein einzelnes Einstellorgan betätigt werden muß.

Weiterhin ist es Ziel der Erfindung, den Platzbedarf für das Bedienfeld klein zu halten und trotzdem eine leichte Bedienbarkeit zu gewährleisten.

Diese Aufgabe wird dadurch gelöst, daß die Einstellung des Klangregelnetzwerkes elektronisch, wie im Anspruch 1 angegeben, erfolgt. Die Speicherung und Abgabe der Einstellsignale wird vom Mikroprozessorsystem des Autoradios gesteuert. Die Eingabe der Einstelldaten durch den Bediener erfolgt über Tasten, wobei Mehrfachbelegung der Tasten vorgesehen ist, um eine übersichtliche Bedieneinheit zu gestalten. Die Auswahl der zu regelnden Funktion erfolgt über Funktionstasten, wobei zur Kontrolle die angewählten Funktionen durch Symbole auf der Anzeigeeinheit dargestellt werden. Nach Auswahl der Funktion - z.B. Klangeinstellung für die Lautsprecher vorne - kann man die Klangfarbe verändern und den veränderten Wert abspeichern. Anschließend wird die nächste Funktion gewählt, in diesem Fall die Klangeinstellung für die Lautsprecher hinten. Die Einstellwerte werden in einem Register abgespeichert. Bei Änderung der Klangeinstellung werden die Registerinhalte für die beiden Lautsprechergruppen gleichermaßen verändert, so daß die Einstelldifferenz erhalten bleibt. Bei dieser Ausführung der getrennten Klangregelung ist es auch leicht möglich, die Einstellung für verschiedene Frequenzbereiche getrennt zu regeln, da nur ein geringer Platzbedarf für die Tasten besteht. Bei Mehrfachbelegung ist kein zusätzlicher Platz für Bedienelemente nötig. Weiterhin ist die Bedienung leicht mit einer Hand möglich und erfordert vom Bediener keine allzu große Aufmerksamkeit, so daß diese Ausführung der getrennten Klangregelung für den Einsatz in Autoradios gut geeignet ist.

Ein Ausführungsbeispiel der Erfindung ist in der Zeichnung dargestellt und wird im folgenden beschrieben:

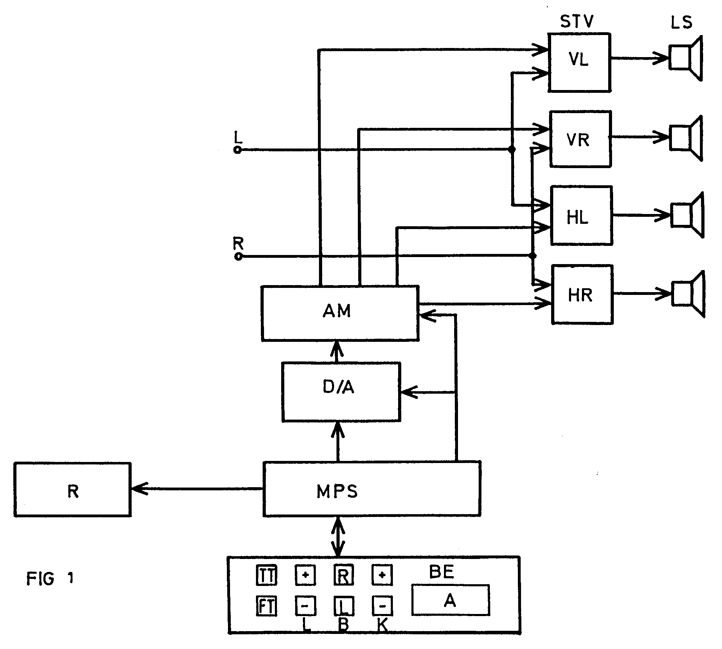

- Fig. 1: zeigt ein Blockschaltbild einer erfindungsgemäßen Anordnung.

In diesem Blockschaltbild werden die für die Erfindung wichtigen Bedienelemente der Bedieneinheit BE dargestellt. Das sind die Funktionstasten FT und TT sowie die Tasten K für die Klangregelung. Bei Klangregelung in mehreren Frequenzbereichen werden diese Tasten mehrfach belegt, oder die Bedieneinheit wird pro Frequenzbereich um einige Tasten erweitert. Die Bedieneinheit BE ist über den Datenbus mit dem Mikroprozessorsystem MPS verbunden. Ebenfalls über den Datenbus sind ein Register R und ein Digital-Analogwandler D/A mit dem Mikroprozessorsystem MPS verbunden. Der Ausgang des Digital-Analog-Wandlers ist mit einem Analogmultiplexer AM verbunden, der die Einstellwerte an die einzelnen Stell- und Verstärkereinheiten STV weitergibt.

Auf diese Weise werden die über die beiden Stereokanäle L und R eintreffenden Tonsignale im Frequenzgang verändert, verstärkt und über die Lautsprecher wiedergegeben.

Eine weitere Verbindung zwischen dem Mikroprozessor MPS und dem Digital-Analog-Wandler D/A bzw. dem Analogmultiplexer AM liefert die erforderliche Clockfrequenz.

Die Eingabe der Einstellwerte erfolgt über die Tastatur der Bedienenheit BE. Für das Einstellen der Klangfarbe benutzt man die Tasten FT und TT sowie das Tastenpaar K. Mit der Funktionstaste FT wird zunächst die Lautsprechergruppe angewählt, für die die Klangeinstellung erfolgen soll. Danach erfolgt die Klangregelung mit den Tasten K in üblicher Weise. Bei Geräten, in denen die Klangregelung in mehreren Frequenzbereichen erfolgt, sind entweder mehrere Tastenpaare K vorhanden oder die Auswahl des zu regelnden Frequenzbereichs wird über die in der Figur dargestellten Funktionstaste TT vorgenommen, wobei bei jedem Drücken der Funktionstaste auf den nächsten Frequenzbereich umgeschaltet wird. Die ausgewählten Funktionen werden zur besseren Übersicht auf der Anzeige A der Bedieneinheit BE dargestellt.

Die Verarbeitung der eingegebenen Daten erfolgt im Mikroprozessorsystem MPS. Über den internen Datenbus werden die Steuerbefehle der Bedieneinheit übernommen und verarbeitet. Diese Verarbeitung umfaßt die Ansteuerung der Anzeige A, die Übergabe der Einstellwerte in das Register R, die Ansteuerung des Digital-Analogwandlers D/A und des Analogmultiplexers AM sowie die Umrechnung der Einstellwerte für die einzelnen Lautsprechergruppen bei gemeinsamer Klangverstellung. Im Register R werden die eingegebenen Einstellwerte abgespeichert, damit sie beim Abschalten des Autoradios nicht verloren gehen. Der Digital-Analogwandler D/A wandelt die digitalen Einstellwerte in die analogen Einstellsignale um. Diese Einstellsignale werden im Analogmultiplexer auf die einzelnen Elemente der Stell- und Verstärkergruppe STV verteilt. Diese Gruppe enthält vier Blöcke von Stell- und Verstärkereinheiten, denen jeweils ein Lautsprecher LS zugeordnet ist. Die Stellgrößen werden im Analogmultiplexer jeweils gehalten, bis neue Werte eingegeben werden, d.h. bis eine Veränderung eintritt.

## Patentansprüche

1. Einrichtung zur Klangregelung in mehreren Frequenzbereichen für verschiedene Lautsprechergruppen, die an einer Audioanlage mit Mikroprozessorsteuerung, insbesondere einer Audioanlage für den Einbau in ein Kraftfahrzeug, angeschlossen sind und bei der die Lautsprecher einer zusammengehörigen Gruppe gleiche akustische Eigenschaften besitzen,
**dadurch gekennzeichnet,** daß
- das Bedienteil (BE) zur anfänglichen selektiven Ansteuerung einer Lautsprechergruppe (VL/VR; HL/HR) bzw. zur Auswahl eines Frequenzbereiches jeweils zugeordnete Funktionstasten (FT; TT) und zur Pegelanhebung bzw. -absenkung separate Tastenpaare (L, B, K) aufweist,
- das Bedienteil (BE) mit einem Display (A) versehen ist, mit dem die jeweils angewählte Lautsprechergruppe und/oder der zu steuernde Frequenzbereich bei der selektiven Voreinstellung angezeigt wird,
- ein als Register (R) dienender nichtflüchtiger Speicher vorgesehen ist, in den vom Mikroprozessor (MPS) die für die einzelnen Funktionsgruppen und/oder Funktionsbereiche festgelegten Steuerdaten als Ausgangsbasis für nachfolgende Rechenoperationen abgelegt werden, und
- der Mikroprozessor (MPS) die im Register (R) gespeicherten Daten bei nachfolgenden gemeinsamen Änderungen der Klangeinstellung so umrechnet, daß die zwischen den verschiedenen Lautsprechergruppen bestehenden Differenzen der Übertragungsfrequenzgänge erhalten bleiben.

## Claims

1. Device for controlling the tone in a number of frequency ranges for various loudspeaker groups which are connected to an audio system with microprocessor control, particularly an audio system for installation in a motor vehicle, and in which the loudspeakers of a group belonging together have the same acoustic characteristics,
characterized in that
- the operating section (BE) for the initial selective activation of a loudspeaker group (VL/VR; HL/HR) and respectively for selecting a frequency range exhibits in each case associated function keys (FT; TT) and separate key pairs (L, B, K) for raising and lowering the level,
- the operating section (BE) is provided with a display (A) by means of which the loudspeaker group in each cage selected and/or the frequency range to be controlled at the selective presetting is indicated,
- a non-volatile memory used as register (R) is provided in which the control data specified for the individual function groups and/or function areas are stored by the microprocessor (MPS) as starting point for subsequent computing operations, and
- the microprocessor (MPS), in the case of subsequent common changes of the tone setting, recalculates the data stored in the register (R) in such a manner that the differences of the transmission frequency responses existing between the individual loudspeaker groups are maintained.

## Revendications

1. Dispositif de réglage de tonalité dans plusieurs gammes de fréquences pour différents groupes de hauts-parleurs, qui sont raccordés à une installation audio comportant une unité de commande à microprocesseur, en particulier à une installation audio destinée à être montée dans un véhicule automobile, et dans lequel des hauts-parleurs d'un groupe homogène possèdent des caractéristiques acoustiques identiques,
caractérisé en ce que
- la partie de commande (BE) comporte, pour la commande initiale sélective d'un groupe de hauts-parleurs (VL/VR; HL/HR) ou pour la sélection d'une gamme de fréquences, des touches fonctionnelles respectivement associées (FT; TT) et, pour l'accroissement ou la réduction du niveau, des couples séparés de touches (L, B, K),
- la partie de commande (BE) est équipée d'un dispositif d'affichage (A), à l'aide duquel le groupe respectivement sélectionné de hauts-parleurs et/ou la gamme de fréquences devant être commandée est affiché lors du préréglage sélectif,
- il est prévu une mémoire non volatile utilisée comme registre (R) et dans laquelle les données de commande, qui sont fixées pour les groupes fonctionnels individuels et/ou les zones fonctionnelles individuelles, sont mémorisés en tant que base de sortie pour des opérations ultérieures de calcul, et
- le microprocesseur (MPS) convertit les données mémorisées dans le registre (R), lors de modifications communes ultérieures du réglage de tonalité, de manière que les différences des allures en fréquence de transmission, qui existent entre les différents groupes de hauts-parleurs, subsistent.
